(19) Europäisches Patentamt / European Patent Office / Office européen des brevets

(11) **EP 2 167 984 B1**

(12) **FASCICULE DE BREVET EUROPEEN**

(45) Date de publication et mention
de la délivrance du brevet:
**22.06.2011 Bulletin 2011/25**

(21) Numéro de dépôt: **08774779.6**

(22) Date de dépôt: **04.07.2008**

(51) Int Cl.:
*G01R 33/09* (2006.01)     *G11B 5/39* (2006.01)

(86) Numéro de dépôt international:
**PCT/EP2008/058701**

(87) Numéro de publication internationale:
**WO 2009/007323 (15.01.2009 Gazette 2009/03)**

(54) **CAPTEUR DE CHAMP MAGNÉTIQUE À FAIBLE BRUIT**

RAUSCHARMER MAGNETFELDSENSOR

LOW-NOISE MAGNETIC FIELD SENSOR

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **10.07.2007 FR 0756394**

(43) Date de publication de la demande:
**31.03.2010 Bulletin 2010/13**

(73) Titulaire: **Commissariat à l'Énergie Atomique et aux Énergies Alternatives
75015 Paris (FR)**

(72) Inventeurs:
• **DIENY, Bernard**
  **F-38250 Lans en Vercors (FR)**
• **BARADUC, Claire**
  **F-38850 Chirens (FR)**
• **PETIT, Sébastien**
  **F-75019 Paris (FR)**
• **THIRION, Christophe**
  **F-38250 Lans en Vercors (FR)**

(74) Mandataire: **Ilgart, Jean-Christophe et al
BREVALEX
95 rue d'Amsterdam
75378 Paris Cedex 8 (FR)**

(56) Documents cités:
**US-A1- 2005 041 342     US-A1- 2005 280 058
US-B1- 6 888 742**

• **HOUSSAMEDDINE D ET AL: "Spin-torque oscillator using a perpendicular polarizer and a planar free layer" NATURE MATERIALS NATURE PUBLISHING GROUP UK, vol. 6, no. 6, juin 2007 (2007-06), pages 447-453, XP002479794 ISSN: 1476-1122**

## Description

## DOMAINE TECHNIQUE

La présente invention concerne le domaine des capteurs de champ magnétique et plus particulièrement celui des vannes de spin ou des jonctions tunnels magnétiques à géométrie de courant perpendiculaire au plan des couches.

Elle trouve notamment application dans le domaine de l'enregistrement magnétique.

## ÉTAT DE LA TECHNIQUE ANTÉRIEURE

Les capteurs de champ magnétique sont utilisés dans de nombreuses applications, têtes de lecture de disques durs d'ordinateurs, dispositifs de lecture de pistes magnétiques, d'encre magnétique, codeurs de position, codeurs angulaires, compas électroniques etc.

Les capteurs de champ magnétique ont fait l'objet de recherches considérables ces dernières années afin de suivre l'augmentation rapide de la densité d'enregistrement sur les disques durs.

Depuis 1992, les capteurs de champ magnétique utilisés dans les têtes de lecture de disques durs d'ordinateurs sont de type magnétorésistif. Dans un capteur de ce type, les variations de champ magnétique modifient la résistance d'un matériau magnétorésistif, ce qui se traduit par des variations de tension aux bornes du capteur.

Les premiers capteurs magnétorésistifs exploitaient l'anisotropie de la magnétorésistance d'une couche mince magnétique, c'est-à-dire la dépendance de la résistance d'une telle couche en fonction de l'angle entre l'aimantation et le courant qui lui était appliqué.

Des capteurs magnétorésistifs plus récents ont été basés sur des vannes de spin. Une vanne de spin est généralement définie comme une structure constituée de deux couches magnétiques séparées par une fine couche de métal non magnétique. L'aimantation d'une des couches magnétiques, dite couche piégée, est maintenue fixe par interaction d'échange avec un matériau antiferromagnétique. L'aimantation de l'autre couche magnétique, dite couche libre ou sensible, est libre de suivre les variations du champ magnétique qui lui est appliqué. La variation d'orientation relative des aimantations respectives des deux couches magnétiques induit un changement de résistance électrique au sein de la couche non magnétique (effet dit de magnétorésistance géante). On trouvera une description des vannes de spin par exemple dans l'article de B. Dieny intitulé « Giant magnetoresistance in spin-valve multilayers », publié dans Journ. Magn. Mater. 136, (1994), pp. 335-359.

Les premières vannes de spin utilisaient une géométrie de courant parallèle au plan des couches selon une configuration dite CIP (*Current In Plane*). La réduction de la taille des bits sur les disques durs (environ 100nm x 40nm en 2006) a conduit à développer des vannes de spin à configuration CPP (*Current Perpendicular* to *Plane*) présentant à la fois un plus haut niveau d'intégration et une plus forte variation de magnétorésistance.

Selon cette configuration, les écrans qui encadrent l'élément magnétorésistif servent également à l'amenée du courant et la prise de tension. On trouvera notamment une description d'une vanne de spin à configuration CPP dans les demandes WO-A-97/44781 US 2005/041342, US 688742 et US 2005/280058.

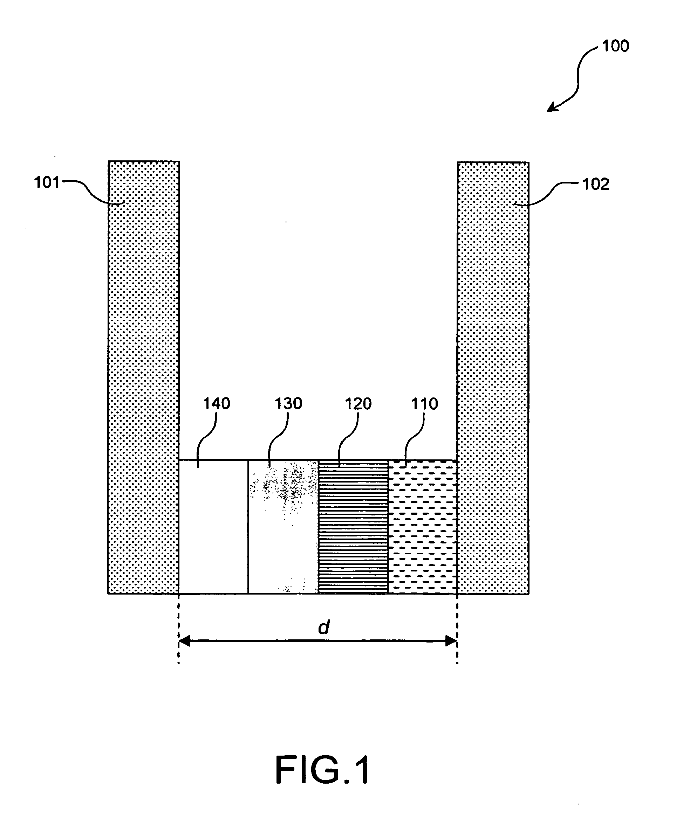

La Fig. 1 illustre schématiquement un capteur magnétorésistif utilisant une vanne de spin 100 à configuration CPP.

Les deux écrans métalliques 101 et 102 servent à délimiter la zone de mesure du champ magnétique ainsi qu'à l'amenée de courant et la prise de tension. La largeur d de cette zone donne la résolution maximale de lecture. La vanne de spin est essentiellement constituée d'une couche antiferromagnétique 110, d'une couche magnétique 120 dont l'aimantation est piégée par la couche 110, d'une couche mince non magnétique 130, et d'une couche magnétique 140 dont l'aimantation est libre de suivre le champ magnétique extérieur. Un champ magnétique de biais (*bias magnetic field*) peut être appliqué à la couche libre 140 au moyen d'un couple d'aimants permanents latéraux (non représentés) de sorte à lui donner une orientation d'aimantation prédéterminée, en l'absence de champ magnétique extérieur.

La résistance de la vanne de spin est faible si les directions des aimantations de la couche libre 140 et de la couche piégée 120 sont parallèles, et élevée dans le cas où elles sont antiparallèles. Lorsqu'un champ magnétique à mesurer est appliqué dans le plan des couches, ce champ produit une rotation de l'aimantation de la couche libre dans ledit plan. L'orientation relative de l'aimantation de la couche libre par rapport à celle de la couche piégée détermine la résistance de la vanne de spin.

Les vannes de spin à configuration CPP présentent, du fait même de leurs petites dimensions, une très faible résistance. Afin de réaliser des capteurs d'impédance adaptée à l'impédance d'entrée typique d'un préamplificateur (typiquement quelques dizaines d'Ohms), on est conduit à utiliser des matériaux magnétorésistifs possédant une forte résistance surfacique (mesurée en $\Omega.\mu m^2$). A cette fin, il a été proposé d'introduire dans la couche séparatrice non magnétique une couche d'oxyde discontinue destinée à confiner localement les lignes de courant. Cette approche conduit cependant à des densités de courant très élevées et, par suite, à des phénomènes d'électromigration préjudiciables à la durée de vie du capteur.

Enfin, la technique la plus prometteuse semble être celle fondée sur l'utilisation de jonctions tunnels magnétorésistives ou MTJs (*Magnetic Tunnel Junctions*). Une jonction MTJ se distingue d'une vanne de spin à configuration CPP en ce que la couche séparatrice 130 est en matériau isolant, par exemple de l'alumine ou de la magnésie (MgO). La barrière tunnel doit avoir une résistance suffisamment faible (mesurée par le produit Résistance*Surface, RA, pour Resistance Area) pour que le capteur ait une résistance compatible avec l'impédance d'entrée du pré-amplificateur et minimiser le bruit de grenaille.

Une caractéristique importante de tout capteur magnétorésistif est le bruit affectant le signal de lecture. Dans les capteurs magnétorésistifs, celui-ci est d'origine diverse. Comme indiqué dans l'article de N. Smith et al. intitulé « White-noise magnetization fluctuations in magnetoresistive heads », publié dans Appl. Phys. Lett. 78 (2001), pp. 1148-1150, lorsqu'une vanne de spin présente une faible variation relative de magnétorésistance, c'est-à-dire un faible rapport $\Delta R/R$, où $\Delta R$ est la variation de résistance entre les états parallèle et antiparallèle, la source prédominante de bruit est d'origine électrique, plus précisément le bruit Johnson résultant du mouvement brownien des électrons de conduction. En revanche, si ce rapport est élevé, la source prédominante de bruit est d'origine magnétique. En effet, dans ce cas, les fluctuations de l'aimantation dans la couche sensible peuvent engendrer des fluctuations importantes de la résistance du capteur. Ces fluctuations de l'aimantation peuvent être induites par l'agitation thermique ou résulter de mouvements irréversibles de parois ou de l'instabilité de domaines magnétiques. Pour une même puissance dissipée, les fluctuations thermiques seront d'autant plus importantes que la taille du capteur sera faible.

De la même façon, pour un capteur à jonction MTJ à faible rapport $\Delta R/R$, la source de bruit prédominante est d'origine électrique, à savoir le bruit de grenaille (*shot noise*) de la jonction tunnel, alors qu'à rapport $\Delta R/R$ élevé, le bruit est essentiellement d'origine magnétique comme indiqué précédemment.

Ainsi, pour les capteurs magnétorésistifs à vannes de spin ou à jonctions tunnel magnétiques de très grande sensibilité (c'est-à-dire à rapport $\Delta R/R$ élevé), le rapport signal à bruit (*SNR*) est essentiellement conditionné par le bruit d'origine magnétique.

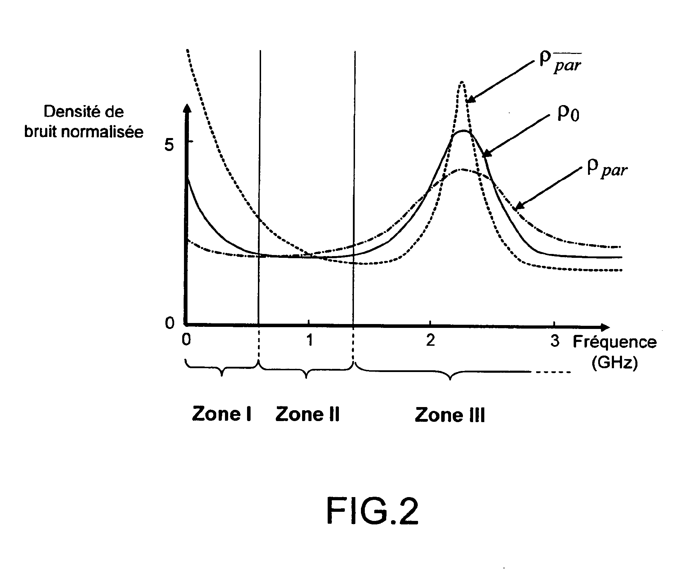

On a représenté en Fig. 2 la courbe typique de densité de puissance de bruit (normalisée par $RI^2$ où $R$ est la résistance du capteur et $I$ le courant le traversant) affectant le signal de mesure dans un capteur magnétorésistif (à base de vanne de spin CPP ou de jonction tunnel magnétique) en fonction de la fréquence $f$ du champ magnétique mesuré (courbe en trait continu notée $\rho_0$. On distingue trois régimes de bruit distincts.

Dans une zone de basse fréquence, notée zone (I), allant de 0 à quelques centaines de MHz, le bruit de mesure est la somme d'un bruit blanc, partiellement d'origine électrique (bruit Johnson ou bruit de grenaille) et partiellement d'origine magnétique (fluctuations thermiques d'aimantation dans la couche sensible du capteur), et d'un bruit en $1/f$ provenant d'une aimantation insuffisante de la couche sensible par le champ magnétique de biais. En effet, une polarisation insuffisante peut donner naissance dans la couche sensible à des parois susceptibles de se piéger ou encore à des domaines magnétiques instables dont l'aimantation peut sauter lors de la rotation de l'aimantation de la couche sensible.

Dans une zone de haute fréquence, notée zone (III), s'étendant typiquement de 1.5 GHz environ à quelques dizaines de GHz, l'allure de la courbe de bruit est due à un phénomène de résonance ferromagnétique dite FMR (*FerroMagnetic Resonance*). Les excitations d'ondes de spin sont activées thermiquement avec un maximum d'amplitude lorsque leur fréquence correspond à la fréquence naturelle de précession de l'aimantation de la couche sensible (FMR).

Une zone intermédiaire, notée zone (II), sépare les zones de basse et de haute fréquence. Dans cette zone, le bruit est essentiellement blanc, le bruit en $1/f$ et la résonance FMR sont quasi-absents.

Le but de la présente invention est par conséquent de proposer une structure de capteur magnétorésistif de très hautes performances (grande sensibilité, faibles dimensions) tout en ayant un niveau de rapport signal sur bruit élevé dans une plage de fréquence d'intérêt.

## EXPOSÉ DE L'INVENTION

La présente invention est définie, par un capteur magnétorésistif comprenant une première couche magnétique d'aimantation piégée, dite première couche piégée, et une couche magnétique d'aimantation libre, dite couche sensible, séparées par une première couche séparatrice de découplage magnétique, ledit capteur comprenant en outre une seconde couche magnétique d'aimantation piégée, dite seconde couche piégée, séparée de ladite couche sensible par une seconde couche séparatrice de découplage magnétique, les première et seconde couches séparatrices étant situées de part et d'autre de ladite couche sensible, les aimantations respectives de ladite première couche piégée et de ladite couche sensible, en absence de champ extérieur, étant sensiblement orthogonales.

Selon un premier mode de réalisation, ledit capteur est adapté à faire circuler un courant continu de la première couche piégée à la seconde couche piégée, et l'aimantation ($\pi_2$) de la seconde couche piégée est orientée dans une direction intermédiaire entre celle de l'aimantation ($\pi_1$) de la première couche piégée et la direction de l'aimantation ($M_0$) de ladite couche sensible, en absence de champ extérieur, les orientations extrêmes étant autorisées.

Selon un second mode de réalisation, ledit capteur est adapté à faire circuler un courant continu de la seconde couche piégée à la première couche piégée, et l'aimantation ($\pi_2$) de la seconde couche piégée est orientée dans une direction intermédiaire entre la direction de l'aimantation ($\pi_1$) de la première couche piégée et la direction opposée à celle de l'aimantation ($M_0$) de ladite couche sensible, en absence de champ extérieur, les orientations extrêmes étant autorisées.

Selon un troisième mode de réalisation, ledit capteur est adapté à faire circuler un courant continu de la première couche piégée à la seconde couche piégée, et l'aimantation ($\pi_2$) de la seconde couche piégée est orientée dans une direction intermédiaire entre la direction opposée à celle de l'aimantation ($\pi_1$) de la première couche piégée et la direction opposée à celle de l'aimantation ($M_0$) de ladite couche sensible, en absence de champ extérieur, les orientations extrêmes étant autorisées.

Selon un quatrième mode de réalisation, ledit capteur est adapté à faire circuler un courant continu de la seconde couche piégée à la première couche piégée, et l'aimantation ($\pi_2$) de la seconde couche piégée est orientée dans une direction intermédiaire entre la direction opposée à celle de l'aimantation ($\pi_1$) de la première couche piégée et celle de l'aimantation ($M_0$) de ladite couche sensible, en absence de champ extérieur, les orientations extrêmes étant autorisées.

Avantageusement, la résistance électrique de l'ensemble couche sensible/première couche séparatrice/première couche piégée est choisie sensiblement plus grande que la résistance électrique de l'ensemble couche sensible/deuxième couche séparatrice/deuxième couche piégée.

Selon une première variante, la première couche séparatrice est une couche mince d'isolant formant une barrière tunnel.

Selon une seconde variante, la première couche séparatrice est une couche métallique.

Selon une troisième variante, la première couche séparatrice est une couche composite métal-isolant, adaptée à confiner localement les lignes de courant.

La seconde couche séparatrice peut être une couche métallique.

Avantageusement, la résistance surfacique de la seconde couche séparatrice est sensiblement plus faible que celle de la première couche séparatrice.

La seconde couche séparatrice peut être également une couche composite métal-isolant, adaptée à confiner localement les lignes de courant.

Le capteur magnétorésistif peut comprendre une première couche ferrimagnétique synthétique, constituée d'une première et d'une seconde sous-couches magnétiques prenant en sandwich une première sous-couche de couplage antiferromagnétique, la première sous-couche magnétique étant piégée par une première couche antiferromagnétique de piégeage, la seconde sous-couche magnétique constituant la première couche piégée.

La première couche séparatrice est en alumine ou en MgO.

La première couche ferrimagnétique synthétique peut être CoFe/Ru/CoFe où les première et seconde sous-couches magnétiques de CoFe ont une épaisseur de 1.5 à 4 nm et la première sous-couche de couplage antiferromagnétique de Ru a une épaisseur de 0.5 à 1 nm.

Alternativement, la première couche ferrimagnétique synthétique peut être CoFe/Ru/CoFeB ou CoFe/Ru/CoFe où la première sous couche magnétique de CoFe a une épaisseur de 1.5 à 4nm et la première sous-couche de couplage antiferromagnétique de Ru a une épaisseur de 0.5 à 1 nm et la seconde sous-couche magnétique est en alliage CoFeB ou CoFe à structure cubique centrée d'épaisseur entre 1.5 et 5nm.

La première couche de piégeage peut être en PtMn, PtPdMn, ou IrMn, par exemple en PtMn avec une épaisseur de 15 à 25 nm.

La couche sensible peut être en alliage CoFe, en particulier $CO_{90}Fe_{10}$.

Alternativement, la couche sensible peut être constituée de deux sous-couches, l'une de Co ou d'alliages CoFe, d'une épaisseur totale de 0.5 à 1.5nm, directement à l'interface avec la première couche séparatrice, l'autre de NiFe d'épaisseur de l'ordre de 2 à 4 nm.

La seconde couche séparatrice peut être en Cu d'épaisseur de 2 à 5 nm.

Le capteur magnétorésistif peut comprendre une seconde couche ferrimagnétique synthétique, constituée d'une troisième et d'une quatrième sous-couches magnétiques prenant en sandwich une seconde sous-couche de couplage antiferromagnétique, la quatrième sous-couche magnétique étant piégée par une seconde couche antiferromagnétique de piégeage, la troisième sous-couche magnétique constituant la seconde couche piégée.

La seconde couche antiferromagnétique de piégeage est en $Ir_{20}Mn_{80}$ d'épaisseur entre 5 et 10nm.

La seconde couche ferrimagnétique synthétique, peut être constituée d'une troisième et quatrième sous-couches magnétiques prenant en sandwich une seconde sous-couche de couplage antiferromagnétique, la quatrième sous-couche magnétique étant piégée par une couche en matériau magnétique dur, la troisième sous-couche magnétique constituant la seconde couche piégée.

Le matériau magnétique dur peut être un alliage à base de Co et de Cr.

La seconde couche piégée peut être en métal de transition ferromagnétique, en particulier un alliage à base de Co, Fe, Ni.

Alternativement, la seconde couche piégée peut être en $Co_{90}Fe_{10}$, d'épaisseur comprise entre 2 et 7 nm.

Atermativement encore, la seconde couche piégée est en alliage CoFeCu ou CoFeAg.

La seconde couche piégée peut être enfin une multicouche laminée ($Co_{90}Fe_{10}$ 1nm/ Cu 0.3nm) ou une bicouche CoFe/NiFe.

Avantageusement, la première couche piégée a son aimantation piégée dans une première direction par une première couche antiferromagnétique de piégeage ayant une première température de blocage, et la seconde couche piégée a son aimantation piégée dans une seconde direction par une seconde couche antiferromagnétique de piégeage ayant une seconde température de blocage distincte de la première.

L'invention est également définie par un procédé de fabrication d'un tel capteur magnétorésistif, selon lequel on dépose successivement sur une électrode la première couche antiferromagnétique de piégeage, la première couche piégée, la première couche séparatrice, la couche sensible, la seconde couche séparatrice, la seconde couche piégée, la seconde couche antiferromagnétique de piégeage, puis :

- si la première température de blocage est supérieure à la seconde température de blocage, on effectue un recuit des couches sous un champ magnétique orienté selon ladite première direction, puis on descend en température jusqu'à la seconde température de blocage, on oriente alors le champ magnétique selon ladite seconde direction et on descend en température jusqu'à la température ambiante ;
- si la seconde température de blocage est supérieure à la première température de blocage, on effectue un recuit des couches sous un champ magnétique orienté selon ladite seconde direction, puis on descend en température jusqu'à la première température de blocage, on oriente alors le champ magnétique selon ladite première direction et on descend en température jusqu'à la température ambiante.

## BRÈVE DESCRIPTION DES DESSINS

D'autres caractéristiques et avantages de l'invention apparaîtront à la lecture d'un mode de réalisation préférentiel de l'invention, fait en référence aux figures jointes parmi lesquelles :

La Fig. 1 illustre schématiquement un capteur magnétorésistif à vanne de spin en configuration CPP, connu de l'état de la technique ;
La Fig. 2 représente la densité de bruit affectant le signal de mesure dans le capteur magnétorésistif de la Fig. 1 ;
La Fig. 3 illustre de manière schématique l'effet de transfert de spin dans une couche magnétique ;
La Fig. 4 illustre schématiquement un capteur magnétorésistif selon un mode de réalisation de l'invention ;
Les Figs. 5A à 5D illustrent différents cas permettant la réduction du bruit d'origine magnétique dans le capteur magnétorésistif de la Fig. 4.

## EXPOSÉ DÉTAILLÉ DE MODES DE RÉALISATION PARTICULIERS

L'idée à la base de l'invention est d'utiliser l'effet dit de transfert de spin pour réduire le bruit d'origine magnétique dans un capteur magnétorésistif.

L'effet de transfert de spin a été prédit dès 1996 dans les vannes de spin de type CPP. On en trouvera une description notamment dans les articles de L. Berger dans Phys. Rev. B Vol. 54, N° 13, pp. 9353-9539 intitulé « Emission of spin waves by a magnetic multilayer traversed by a current » et J.C. Slonczewski dans Journal Magn. Magn. 159 (1996) L1-L7, intitulé « Current-driven excitation of magnetic layers ».

L'effet de transfert de spin peut être considéré comme l'effet dual de celui de magnétorésistance. Alors que le phénomène de magnétorésistance permet de contrôler un courant électrique à partir de l'aimantation d'une couche magnétique, celui de transfert de spin permet d'agir sur l'aimantation d'une couche magnétique libre à partir d'un courant polarisé en spin. Plus précisément, lorsqu'un tel courant circule perpendiculairement à une couche magnétique, le spin des électrons de conduction dans cette couche se réoriente très rapidement parallèlement à l'aimantation locale, ce qui implique une rotation du plan de polarisation en spin des électrons. Cette rotation produit un transfert de moment angulaire à l'aimantation de la couche magnétique, ce qui se traduit par un couple magnétique sur cette couche.

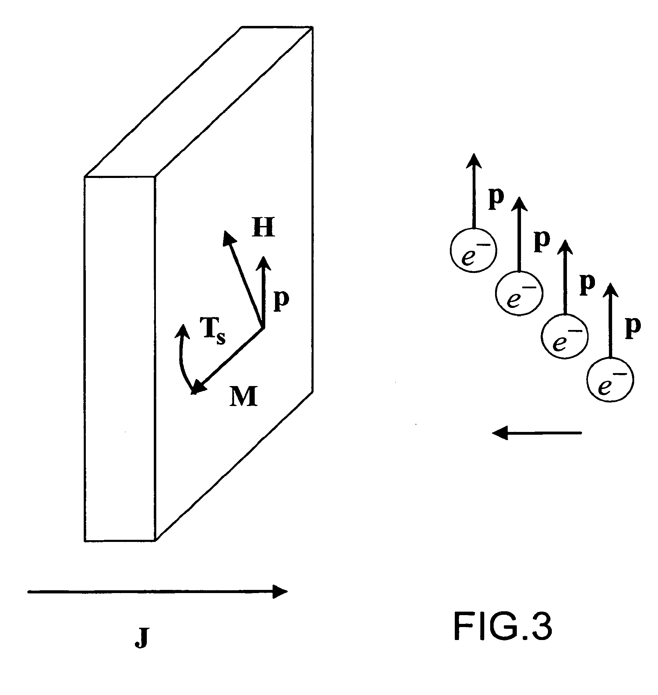

La Fig. 3 illustre l'effet de transfert de spin. On a noté **J** le courant, polarisé en spin dans la direction **p**, où **p** est un vecteur unitaire orienté dans le sens de polarisation. Ce courant traverse une couche magnétique d'aimantation **M**.

On peut montrer que l'équation gouvernant la dynamique de l'aimantation peut s'écrire (équation de Landau, Lifschitz, Gilbert ou LLG, corrigée du terme de Slonczewski) :

$$\frac{d\mathbf{M}}{dt} = -\gamma\left(\mathbf{M}\times\mathbf{H}\right) + \gamma\frac{a_j(\theta)}{M_s}\mathbf{M}\times\left(\mathbf{M}\times\mathbf{p}\right) + \frac{\alpha}{M_s}\mathbf{M}\times\frac{d\mathbf{M}}{dt} \qquad (1)$$

où **H** est le champ magnétique effectif dans la couche, $\gamma$ est le coefficient gyromagnétique, $\alpha$ est un coefficient d'amortissement, dit de Gilbert, $\boldsymbol{M_s}$ est l'aimantation de saturation dans la couche, et

$$a_j(\theta) = \frac{\hbar}{2e}\frac{g(\theta)}{M_s\delta}j \qquad (2)$$

où j est la densité de courant polarisé en spin, $\delta$ est l'épaisseur de la couche, $g(\theta)$ est un facteur d'efficacité dépendant de l'angle $\theta$ entre la direction de polarisation **p** et l'aimantation **M** de la couche, $\hbar$ est la constante de Planck et e la charge électrique de l'électron.

Le premier terme de droite de l'équation (1) est un couple de précession de l'aimantation autour du champ magnétique effectif **H**. On appelle champ magnétique effectif le champ magnétique effectivement subi par la couche, à savoir la somme du champ extérieur appliqué, du champ de démagnétisation et du champ d'anisotropie. Le second terme représente un couple de transfert de spin **T$_s$** tendant à aligner l'aimantation de la couche dans la direction de la polarisation de spin ou dans la direction opposée, selon le signe du courant. Enfin, le dernier terme correspond à un amortissement du mouvement de l'aimantation.

Afin de mieux comprendre l'invention, on analysera tout d'abord l'effet du transfert de spin dans une structure magnétorésistive classique, telle que celle représentée en Fig. 1.

Différents régimes se produisent suivant la valeur de la densité de courant relativement à la densité de courant critique $j_c$ permettant la commutation de l'aimantation par transfert de spin.

Pour un matériau à aimantation planaire, Li et Zhang ont montré dans l'article « Magnetization dynamics with a spin-transfer torque » publié dans Physical Review B 68, 024404 (2003) que la commutation magnétique par transfert de spin se produit pour une densité critique de courant $j_c$ correspondant à un $a_j^{critique}$ donné par l'expression (2) tel que $a_j^{critique} = \alpha\left(2\pi M_s + H_K\right)$, $H_k$ étant le champ d'anisotropie magnétique de la couche magnétique considérée, les autres grandeurs ayant été définies à propos de l'expression (1). Typiquement, dans les vannes de spin usuelles en géométrie de courant CPP, $j_c$ est de l'ordre de quelques $10^7 A/cm^2$. Dans les jonctions tunnels à base de MgO, $j_c$ a pu être réduit à des valeurs de l'ordre de $10^6 A/cm^2$ grâce à la plus forte polarisation en spin des électrons traversant la barrière tunnel et grâce à l'utilisation de matériaux à plus faible aimantation et faible amortissement de Gilbert.

Pour une densité de courant nettement inférieure la valeur de densité critique $j_c$ (typiquement inférieure à $j_c/10$, l'effet de transfert de spin n'est pratiquement pas perceptible car le couple magnétique exercé par le courant polarisé en spin est trop faible pour agir sur l'aimantation de la couche sensible.

Pour des densités de courant de l'ordre de $j_c$ à un peu inférieure à $j_c$, c'est-à-dire typiquement de l'ordre de l'ordre de quelques $10^5 A/cm^2$ à quelques $10^6 A/cm^2$, l'effet de transfert de spin devient perceptible et ceci bien avant que la densité de courant ne soit suffisante pour provoquer la commutation magnétique par transfert de spin. L'effet dépend, d'une part, des orientations respectives de la polarisation de spin et de l'aimantation de la couche sensible et, d'autre part, du sens du courant.

On supposera tout d'abord que les aimantations de la couche piégée et de la couche sensible sont parallèles.

Si le courant circule de la couche sensible vers la couche piégée, c'est-à-dire si les électrons vont de la couche piégée à la couche sensible, le courant favorise un alignement parallèle de l'aimantation de la couche sensible par rapport à l'aimantation de la couche piégée. On comprend par conséquent que l'effet de transfert de spin stabilise l'aimantation de la couche sensible, ce qui a pour effet de réduire les fluctuations magnétiques dans cette couche. Cela se traduit par une diminution du bruit d'origine magnétique dans la zone (I) de la Fig. 2. Cette zone de fonctionnement correspond à une plage de fréquences définie en fonction de la fréquence $f_0$ de la raie de résonance FMR, et de la demi-largeur $\Delta f$ de cette raie mesurée à mi-hauteur du pic, sur une représentation en puissance, avec une échelle linéaire des amplitudes et des fréquences. Plus précisément, la zone I peut être approximativement définie comme correspondant à la plage de fonctionnement $]0,\max(100\boldsymbol{MHz}, f_0\text{-}3\Delta\mathbf{f})]$.

On peut montrer également que dans ces conditions de configuration magnétique et de sens du courant, l'effet

**EP 2 167 984 B1**

de transfert de spin accroît le terme d'amortissement dans l'équation (1). Cela se traduit par un élargissement de la raie de résonance FMR dans la zone (III) de la Fig. 2. Cela correspond à une augmentation du niveau moyen de bruit dans les gammes de fréquence correspondant aux pieds de cette raie de résonance FMR, en particulier au voisinage de la limite entre la zone II et la zone III de la Fig.2.

Si maintenant le courant circule de la couche piégée vers la couche sensible, c'est-à-dire si les électrons vont de la couche sensible vers la couche piégée, le courant favorise un alignement antiparallèle de l'aimantation de la couche sensible et celle de la couche piégée. Physiquement, les électrons issus de la couche sensible qui possèdent une polarisation antiparallèle à celle de la couche piégée sont réfléchis par cette dernière et tendent à inverser l'aimantation de la couche sensible lorsqu'ils interagissent à nouveau avec celle-ci. On comprendra que l'effet de transfert de spin rende instable l'aimantation de la couche sensible et en accroisse les fluctuations. Cela se traduit par une augmentation du bruit d'origine magnétique dans la zone (I) de la Fig. 2. On peut montrer également que l'effet de transfert de spin dans ce régime est équivalent à une diminution du coefficient d'amortissement de Gilbert $\alpha$ dans l'équation (1). Cela se traduit par un rétrécissement de la raie de résonance FMR dans la zone (III) de la Fig. 2, et corrélativement à une diminution du niveau de bruit dans les gammes de fréquence correspondant au pied de cette raie, en particulier dans la zone de transition entre les zones II et III de la Fig.2. Cette zone de transition peut être approximativement définie par la plage de fonctionnement $]\mathrm{max}(10\,MHz, f_0\text{-}3\Delta f),\ f_0\text{-}1,5\Delta f].$

Les courbes de densité de bruit, en présence de transfert de spin, ont été représentées en Fig. 2 dans le cas où le courant circule de la couche sensible vers la couche piégée. On a noté respectivement $\rho_{par}$ et $\rho_{\overline{par}}$ les courbes typiques de bruit dans la situation où les aimantations des couches sensible et piégée sont respectivement en alignement parallèle et antiparallèle. Si le courant circule de la couche piégée vers la couche sensible, les courbes $\rho_{par}$ et $\rho_{\overline{par}}$ sont interverties.

Nous supposons maintenant que les aimantations respectives de la couche piégée et de la couche sensible sont antiparallèles.

Les conclusions exposées précédemment doivent alors être inversées.

Plus précisément, si le courant circule de la couche sensible vers la couche piégée, l'effet de transfert de spin tend à ramener l'aimantation de la couche sensible parallèle à celle de la couche piégée ce qui rend la couche magnétique instable, avec pour conséquence un accroissement du bruit d'origine magnétique dans la zone (I) de la Fig. 2 et un rétrécissement de la raie de résonnance dans la zone (III).

En revanche, si le courant circule de la couche piégée vers la couche sensible, l'effet de transfert de spin tend à renforcer l'alignement antiparallèle des aimantations des couches sensible et piégée ce qui stabilise l'aimantation de la couche sensible, avec pour conséquence une diminution du bruit d'origine magnétique dans la zone (I) de la Fig. 2 et un élargissement de la raie de résonnance dans la zone (III).

Le contrôle du bruit magnétique par transfert de spin est réalisé dans la présente invention en rajoutant dans la structure magnétorésistive (vanne de spin CPP ou jonction MTJ) une seconde couche piégée, dont l'aimantation est orientée dans une direction particulière qui sera précisée plus loin. La seconde couche piégée permet de polariser en spin le courant traversant la couche sensible, et, par un choix approprié de l'orientation de l'aimantation de cette seconde couche piégée, d'agir sur la densité de fluctuations magnétiques qui peuvent y apparaître et donc sur l'amplitude de bruit d'origine magnétique qui en résulte.

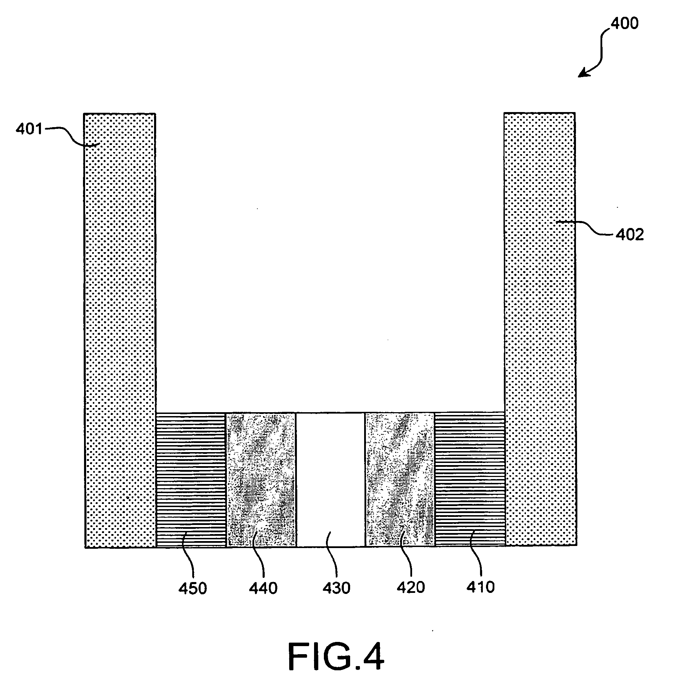

La Fig. 4 illustre la structure d'un capteur selon un mode de réalisation de l'invention.

Le capteur 400 comprend deux écrans métalliques 401 et 402 servant d'une part à délimiter la zone de mesure du champ magnétique, d'autre part à amener un courant continu et à récupérer la tension de mesure.

Il comprend en outre, comme dans l'art antérieur, une première couche magnétique 410, dont l'aimantation est piégée par une couche antiferromagnétique (non représentée), et une couche magnétique libre 430, constituant la couche sensible. Une première couche séparatrice non magnétique 420 permet le découplage des deux couches magnétiques. La couche séparatrice peut être une couche métallique, typiquement en Cu, comme dans les vannes de spin. Elle peut être aussi constituée d'une couche d'oxyde discontinue percée de chemins métalliques pour confiner les lignes de courant et ainsi augmenter la résistance CPP du capteur (structure dite à chemins de courant confinés ou « current confined path » en anglais). Enfin, cette couche séparatrice peut être constituée d'une fine couche semiconductrice ou isolante, par exemple de l'alumine ou du MgO comme dans les jonctions tunnels magnétiques.

La couche antiferromagnétique peut être constituée d'un alliage IrMn, PtMn, PtPdMn. La couche piégée est par exemple une couche simple de CoFe 3nm ou bien fait partie d'une structure antiferromagnétique synthétique Co-Fe/Ru/CoFe comme on le verra plus loin.

La première couche magnétique piégée 410 possède une aimantation orientée selon une direction fixe, sensiblement parallèle à la direction du champ magnétique que l'on cherche à mesurer. La couche magnétique libre possède, en absence de champ magnétique appliqué, une aimantation dans le plan de celle-ci, sensiblement orthogonale à l'aimantation de la première couche. Cette orientation orthogonale peut être obtenue en appliquant un champ magnétique de biais (*bias magnetic field*) au moyen d'un couple d'aimants permanents latéraux, par exemple en alliage CoCr, situés de part et d'autre de l'élément magnétorésistif. Alternativement, dans le cas où cet élément est une jonction tunnel, l'orientation orthogonale de l'aimantation de la couche libre peut être obtenue par une couche d'aimant permanent située dans l'empilement (*in-stack bias*) entre la jonction tunnel et les écrans métalliques servant à l'amenée du courant. L'aimantation de la couche d'aimant permanent est choisie dans le plan des couches et orthogonale à celle de la couche piégée. En se refermant en partie à travers la couche libre de la jonction tunnel, le champ magnétique généré par la couche d'aimant permanent polarise la couche libre dans la direction souhaitée.

Le choix d'une polarisation orthogonale dans la couche sensible permet d'obtenir une réponse linéaire du capteur, la magnétorésistance de la vanne de spin ou de la jonction tunnel variant comme le cosinus de l'angle entre les aimantations de la couche sensible et de la couche piégée.

A la différence de l'art antérieur, le capteur 400 comprend en outre une seconde couche magnétique piégée 450, isolée magnétiquement de la couche libre 430 par une seconde couche séparatrice non magnétique 440. La seconde couche séparatrice est de préférence une couche conductrice, par exemple une couche métallique. Elle peut aussi être une couche mince isolante formant une barrière tunnel ou bien encore une couche d'oxyde discontinue percée de chemins métalliques pour confiner les lignes de courant.

La seconde couche magnétique possède une aimantation dont l'orientation est choisie, comme précisé ci-après, pour réduire ou accroître les fluctuations magnétiques dans la couche sensible selon que le capteur va fonctionner vers la zone I de fréquence ou vers la frontière entre les zones II et III c'est-à-dire au voisinage du pied de la raie de résonance FMR (cf. Fig. 2). L'aimantation de la couche sensible subit en effet l'influence conjuguée du transfert de spin dû aux deux couches magnétiques piégées.

Nous supposerons tout d'abord que le capteur magnétorésistif opère dans la bande de fréquence de la zone (I) telle que définie plus haut en relation avec la Fig. 2.

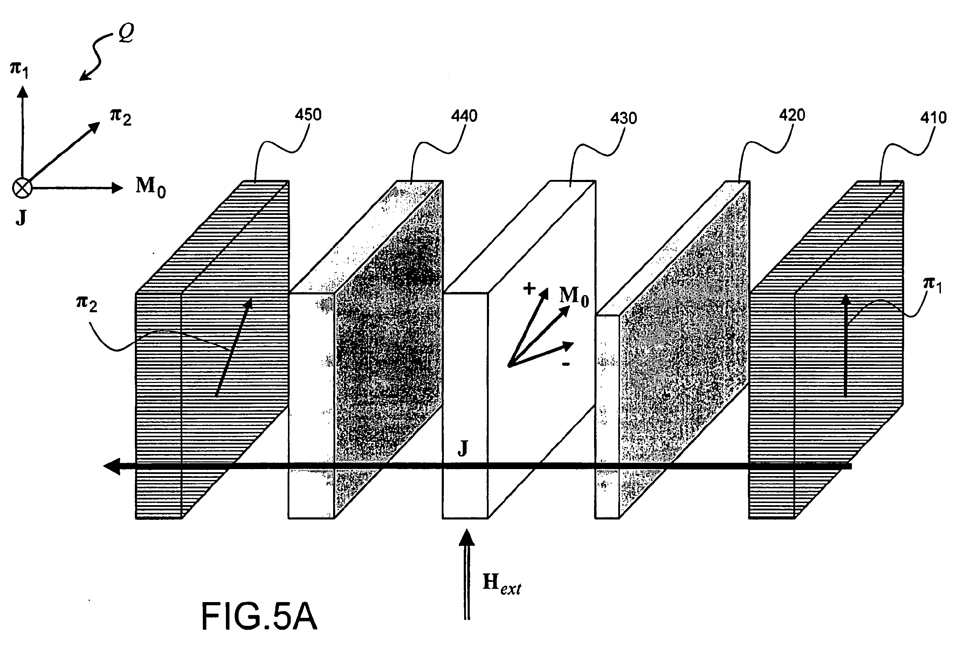

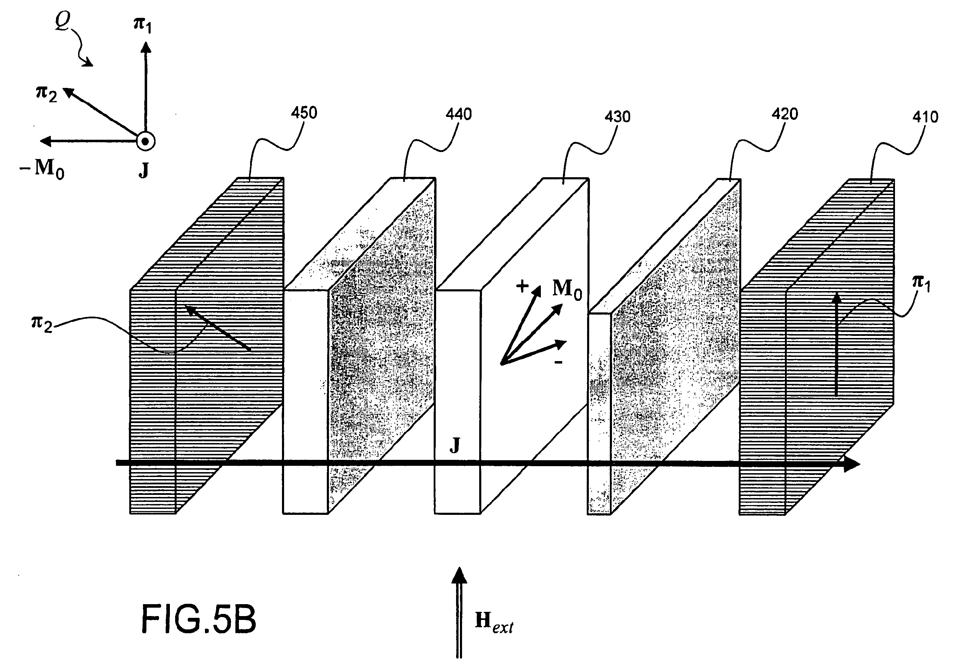

La configuration permettant de réduire le bruit magnétique est illustrée, en vue éclatée, en Fig. 5A, lorsque le courant circule de la première couche piégée à la seconde couche piégée et en Fig. 5B lorsqu'il circule en sens inverse.

En absence de champ extérieur appliqué, la direction de l'aimantation de la couche libre est sensiblement orthogonale à celle de la première couche piégée, comme indiqué par $M_0$ sur les figures. L'effet de transfert de spin sur l'aimantation de la couche sensible, dû à la première couche piégée, est alors intermédiaire entre celui d'une configuration parallèle et celui d'une configuration antiparallèle, c'est-à-dire comprend à la fois une action stabilisatrice et une action déstabilisatrice. L'orientation de l'aimantation de la seconde couche piégée est ici choisie de manière à diminuer l'action déstabilisatrice et à renforcer l'action stabilisatrice.

Lorsque le courant $J$ circule de la première à la seconde couche piégée, c'est-à-dire lorsque les électrons vont de la seconde à la première couche piégée, la direction d'aimantation de la seconde couche piégée, notée $\pi_2$, est choisie orientée selon une direction intermédiaire (les limites extrêmes étant comprises) entre celle de l'aimantation de la première couche piégée, notée $\pi_1$, et celle de l'aimantation de la couche sensible, en l'absence de champ magnétique extérieur, comme illustré en Fig. 5A. Autrement dit, l'aimantation de la seconde couche piégée est située dans le quadrant $Q$ défini par l'aimantation de la première couche piégée et l'aimantation de la couche sensible, en absence de champ extérieur, les limites extrêmes du quadrant étant autorisées.

En revanche, lorsque le courant $J$ circule de la seconde à la première couche piégée, c'est-à-dire lorsque les électrons vont de la première à la seconde couche piégée, la direction d'aimantation, de la seconde couche piégée, $\pi_2$, est choisie orientée selon une direction intermédiaire (les limites extrêmes étant comprises) entre la direction de l'aimantation de la première couche piégée, $\pi_1$, et la direction opposée de l'aimantation de la couche sensible, en absence de champ magnétique extérieur, comme illustré en Fig. 5B. Autrement dit, l'aimantation de la seconde couche piégée est située dans le quadrant défini par l'aimantation de la première couche piégée et l'opposée de l'aimantation de la couche sensible, en absence de champ extérieur, les limites extrêmes du quadrant étant autorisées.

Dans le cas de la Fig. 5A ou 5B, l'action déstabilisatrice, par effet de transfert de spin, de la première couche piégée est compensée par l'action stabilisatrice de la deuxième couche piégée grâce à la composante d'aimantation de cette deuxième couche piégée parallèle à celle de la première couche piégée. Par ailleurs, grâce à la composante de l'aimantation de la deuxième couche piégée, parallèle ou antiparallèle (suivant la direction du courant) à l'aimantation de la couche sensible en champ nul, l'aimantation de la couche piégée a un effet stabilisateur sur l'aimantation de la couche sensible.

On comprendra qu'ainsi les configurations des Figs. 5A et 5B permettent, selon le sens du courant, de réduire le bruit d'origine magnétique dans un capteur opérant dans la bande de fréquence de la zone (I).

Enfin, le choix de l'orientation précise de l'aimantation de la seconde couche piégée à l'intérieur d'un quadrant permet de pondérer les effets de transfert de spin à l'intérieur de la couche sensible, dus respectivement aux première et seconde couches piégées, et de régler ainsi le niveau de stabilisation souhaité. Cette orientation est déterminée par l'amplitude relative des préfacteurs $a_j(\theta)$ dans le terme de Slonczewski (cf. expression (2)) associés à la première et seconde couche piégée. Ce préfacteur est lui-même proportionnel à la polarisation du courant provenant de chacune de ces couches. L'angle relatif de $\pi_2$ par rapport à $\pi_1$ est de préférence déterminé expérimentalement.

Nous supposerons maintenant que le capteur magnétorésistif opère dans la bande de fréquence de transition entre les zones II et III de la Fig. 2, telle que définie plus haut, c'est-à-dire au pied du pic de résonance FMR.

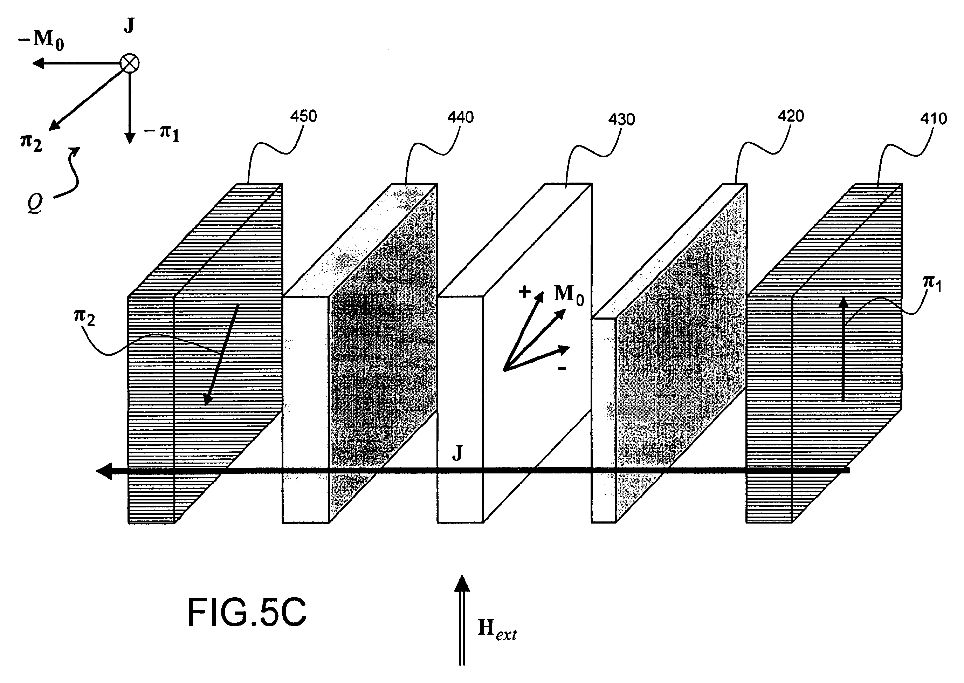

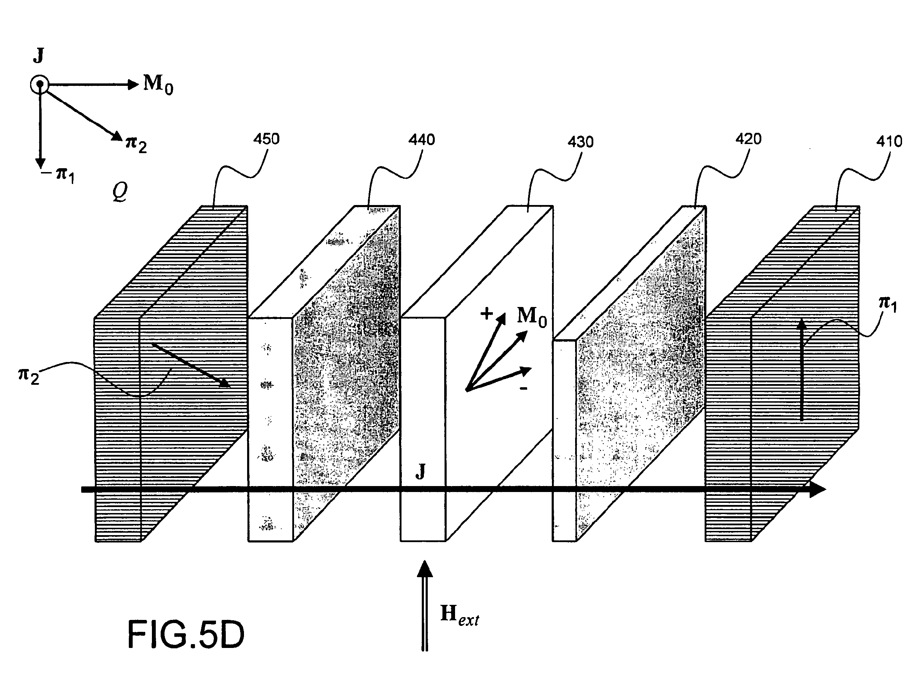

La configuration permettant de réduire le bruit magnétique est illustrée en Fig. 5C, lorsque le courant circule de la première couche piégée à la seconde couche piégée et en Fig. 5D lorsqu'il circule en sens inverse.

Lorsque le courant circule de la première à la seconde couche piégée, c'est-à-dire lorsque les électrons vont de la seconde à la première couche piégée, la direction d'aimantation de la seconde couche piégée est choisie orientée selon une direction intermédiaire (les orientations limites étant comprises) entre l'opposée de celle de la première couche piégée et l'opposée de celle de la couche sensible, en l'absence de champ magnétique extérieur, comme illustré en Fig. 5C. Autrement dit, l'aimantation de la seconde couche piégée est située dans le quadrant **Q** défini par l'opposée de l'aimantation de la première couche piégée et l'opposée de l'aimantation de la couche sensible, en absence de champ extérieur, les limites extrêmes du quadrant étant autorisées.

En revanche, lorsque le courant circule de la seconde à la première couche piégée, c'est-à-dire lorsque les électrons vont de la première à la seconde couche piégée, la direction d'aimantation de la seconde couche piégée est choisie orientée selon une direction intermédiaire (les limites extrêmes étant comprises) entre l'opposée de la direction d'aimantation de la première couche piégée et la direction de l'aimantation de la couche sensible, en absence de champ magnétique extérieur, comme illustré en Fig. 5D. Autrement dit, l'aimantation de la seconde couche piégée est située dans le quadrant **Q** défini par l'opposée de l'aimantation de la première couche piégée et la direction d'aimantation de la couche sensible, en absence de champ extérieur, les limites extrêmes du quadrant étant autorisées.

Dans le cas de la Fig. 5C ou 5D, les actions déstabilisatrices, par effet de transfert de spin, des deux couches piégées, se cumulent.

Le cumul des actions déstabilisatrices entraîne une diminution du coefficient d'amortissement intervenant dans l'équation dynamique de l'aimantation de la couche sensible (1) et, par conséquent un rétrécissement de la raie de résonnance FMR ainsi qu'un abaissement du niveau de bruit dans les gammes de fréquence correspondant aux pieds de la raie de résonance FMR.

On comprendra qu'ainsi les configurations des Figs. 5C et 5D permettent, selon le sens du courant, de réduire le bruit d'origine magnétique dans un capteur magnétorésistif opérant dans la bande de fréquence de transition précitée.

Pour ce qui concerne la magnétorésistance du capteur selon l'invention, celle-ci peut être considérée en première approximation comme provenant de deux structures sandwiches magnétorésistives en série, à savoir :

- une première structure sandwich constituée par la première couche magnétique piégée 410, la première couche séparatrice 420 et la couche magnétique sensible 430, et

- une seconde structure sandwich constituée par la couche magnétique sensible 430, la seconde couche séparatrice 440 et la seconde couche magnétique piégée 450.

Les résistances associées à ces deux structures sandwich peuvent être considérées en première approximation comme étant en série. Ainsi la magnétorésistance de l'empilement global va être pondérée par le poids relatif de ces deux résistances. Pour la linéarité du capteur, il est préférable que la magnétorésistance provienne de façon largement prépondérante de la première structure sandwich dont les aimantations de la couche sensible en champ nul et piégée sont orientées sensiblement à 90° l'une de l'autre. De ce fait, il est préférable que la seconde couche séparatrice soit une couche conductrice, par exemple une couche métallique de faible résistance. Par contre, la première couche séparatrice est de préférence une couche mince isolante formant une barrière tunnel ou une couche isolante discontinue percée de chemins métalliques destinés à confiner localement le courant. Ainsi, la magnétorésistance est essentiellement déterminée par celle de la première structure susmentionnée.

La première couche séparatrice peut également être une couche métallique. Toutefois, dans ce cas les poids en termes de résistance des première et deuxième structures sandwichs magnétorésistives vont être comparables. Pour avoir un effet additif des magnétorésistances de ces deux contributions, il faudra alors veiller à préférentiellement se trouver dans les cas illustrés par les figures 5a et 5b (angle relatif entre les aimantations des deux couches piégées inférieur à 90°).

Le capteur magnétorésistif selon l'invention peut être réalisé de la manière suivante.

On procède tout d'abord, de préférence, au dépôt d'une couche tampon non-magnétique sur une électrode d'amenée de courant, par exemple l'un des écrans métalliques délimitant la zone de mesure. Cette couche tampon a pour but de promouvoir la croissance de la structure et peut être constituée par exemple par NiFeCr 5nm. On réalise ensuite successivement :

(a) une première couche antiferromagnétique de piégeage par exemple en PtMn, PtPdMn, ou IrMr, préférentiellement en PtMn d'épaisseur 15 à 25nm ; puis, soit l'option (b1) ou l'option (b2) suivante :

(b1) une couche magnétique simple directement en contact avec la couche antiferromagnétique, par exemple une couche en alliage CoFe, riche en Co, d'épaisseur typiquement entre 2 et 5nm. Cette couche simple constitue alors la première couche magnétique piégée du capteur selon l'invention ; ou bien

(b2) une couche composite ferrimagnétique artificielle constituée par :

- une première sous-couche piégée en contact avec la couche antiferromagnétique, par exemple une couche en alliage CoFe riche en Co d'épaisseur typiquement entre 1.5nm et 4nm ;
- une couche de couplage antiferromagnétique de Ru d'épaisseur typique entre 0.5 et 1nm ;
- une seconde sous-couche piégée qui constitue alors la première couche magnétique piégée du capteur selon l'invention. Cette seconde couche peut être en CoFe riche en Co, d'épaisseur typiquement de 1.5nm à 4nm, si la couche suivante (première couche séparatrice) est métallique ou isolante percée de chemins métalliques destinés à confiner localement le courant. Elle peut être en CoFeB ou en CoFe, de structure cubique centrée, si la couche suivante est isolante de structure cubique centrée, comme en MgO ; L'épaisseur de cette couche est typiquement de 1.5nm à 5nm.

(c) une couche non magnétique constituant la première couche séparatrice du capteur selon l'invention. Comme on l'a déjà dit, elle est de préférence isolante, par exemple en Alumine, MgO ou $TiO_x$, pour réaliser une barrière tunnel. Elle peut être aussi métallique, par exemple en Cu, pour réaliser une vanne de spin. Elle peut être enfin une couche composite d'isolant et de métal, pour réaliser une structure à confinement de courant ;

(d) une couche en alliage CoFe riche en Co, en particulier $Co_{90}Fe_{10}$, constituant la couche libre (ou sensible) du capteur selon l'invention. Cette couche peut être alternativement formée par l'association de deux sous-couches, l'une de Co ou d'alliages CoFe, d'épaisseur de 0.5 à 1.5nm, directement en contact avec la première couche séparatrice, l'autre de NiFe de 1.5nm à 4nm d'épaisseur pour augmenter la douceur magnétique de la couche précédente. Une troisième sous-couche par exemple de Co ou d'alliages CoFe, d'épaisseur de 0.5 à 1.5nm peut encore être rajoutée aux deux précédentes à l'interface avec la deuxième couche séparatrice pour éviter les effets d'interdiffusion entre le NiFe et la deuxième couche séparatrice.

Cependant, si la première couche séparatrice sous-jacente est en MgO avec une structure cubique centrée, on préfèrera utiliser un alliage CoFe présentant la même structure ou un alliage CoFeB amorphe que l'on recuira ensuite. On réduit ainsi les mésappariements de réseau à l'interface ;

(e) une couche non magnétique constituant la seconde couche séparatrice du capteur selon l'invention. Elle est de préférence métallique, typiquement en Cu, d'épaisseur de l'ordre de 2 à 5nm. Elle peut être également en d'autres matériaux comme Au, Zr, Hf Rh. Cette couche doit être suffisamment épaisse pour assurer le découplage magnétique entre la couche magnétique sensible et la seconde couche magnétique piégée tout en étant la plus mince possible pour ne pas trop augmenter l'épaisseur totale du capteur, cette épaisseur définissant la résolution de la tête de lecture ;

(f) une couche magnétique, constituant la seconde couche magnétique piégée du capteur selon l'invention.
Cette couche doit être apte à polariser en spin le courant. On choisira avantageusement un matériau présentant des effets de diffusion ou de transmission de spin, dans son volume et/ou à ces interfaces, suffisamment forts pour induire une asymétrie entre les courants de spin parallèle et antiparallèle à son aimantation.
Selon une première variante, on choisira un matériau ayant une faible longueur de diffusion de spin, de manière à minimiser l'épaisseur de la couche. En effet, la polarisation en spin du courant s'acquiert typiquement sur une longueur de l'ordre de la longueur de diffusion de spin $\ell_{SF}$ (dans un métal). On utilisera par exemple du Permalloy ($Ni_{80}Fe_{20}$) présentant une $\ell_{SF}$ de l'ordre de 5nm à 300K.
Selon une seconde variante, en alternative ou en complément à la première variante, on utilise des effets de diffusion de spin à une interface pour créer cette polarisation. Il est connu par exemple qu'à la traversée d'une interface Co/Cu, le courant d'électrons se dépolarise d'environ 30%. On peut alors laminer la couche magnétique par insertion de fines couches de Cu pour tirer avantage de cet effet et favoriser la polarisation en spin du courant.
La seconde couche magnétique piégée peut ainsi être en métal de transition ferromagnétique (par exemple des alliages à base de Co, Fe, Ni typiquement $Co_{90}Fe_{10}$ d'épaisseur typique entre 2 et 7nm), ou bien être constituée d'un empilement de plusieurs couches (par exemple une multicouche laminée ($Co_{90}Fe_{10}$ 1nm/Cu0.3nm)$_3$ ou lamination CoFe/NiFe), ou d'un alliage hétérogène (par exemple CoFeCu ou CoFeAg riche en Co). Si l'élément magnétorésistif est une jonction tunnel ou une structure à confinement de courant, on peut utiliser aussi des matériaux plus résistifs comme des oxydes magnétiques (par exemple magnétite) donnant de fortes polarisations en spin.
Enfin, la seconde couche magnétique piégée peut faire partie d'une couche composite ferrimagnétique synthétique, ce qui permet d'améliorer son piégeage et de diminuer l'influence de son champ rayonné sur l'aimantation de la couche douce.

(g) une seconde couche antiferromagnétique de piégeage par exemple en $Ir_{20}Mn_{80}$ d'épaisseur typiquement entre 5 et 10nm. Une telle couche a une température de blocage de l'ordre de 200°C, inférieure à la température de blocage de PtMn (~300°C). Pour orienter l'aimantation de la couche première couche piégée selon une première direction et l'aimantation de la seconde couche piégée selon une seconde direction, on peut effectuer un premier recuit à 300°C sous un champ magnétique orienté dans la première direction, puis refroidir la structure dans le même champ jusqu'à 200°C. On applique ensuite un champ magnétique orienté selon la seconde direction puis on abaisse la température jusqu'à l'ambiante.

De manière, générale on pourra procéder ainsi dès lors que l'on dispose de deux matériaux antiferromagnétiques de températures de blocage distinctes. Soit $t_1$ (resp. $t_2$) la température de blocage de la première (resp. seconde) couche antiferromagnétique de piégeage. Si $t_1 > t_2$, on effectue un recuit à $t_1$ des couches sous un champ magnétique orienté selon la direction souhaitée pour l'aimantation de première couche de piégeage, puis on descend en température jusqu'à $t_2$, on oriente alors le champ magnétique selon la direction souhaitée pour l'aimantation de seconde couche de piégeage et, on descend en température jusqu'à la température ambiante. Si $t_2 > t_1$, on procède de manière inverse : on effectue un recuit à $t_2$ des couches sous un champ magnétique orienté selon ladite seconde direction, puis en descend en température jusqu'à $t_1$, on oriente alors le champ magnétique selon ladite première direction et on descend en température jusqu'à la température ambiante.

Selon une variante, la seconde couche de piégeage peut être une couche en matériau magnétique dur, par exemple en CoCr. Dans ce cas, la direction d'aimantation de cette couche peut être établie en appliquant un fort champ magnétique apte à saturer son aimantation dans la direction souhaitée.

## Revendications

**1.** Capteur magnétorésistif comprenant une première couche magnétique d'aimantation piégée (410), dite première couche piégée, et une couche magnétique d'aimantation libre (430), dite couche sensible, séparées par une première couche séparatrice (420) de découplage magnétique, **caractérisé en ce qu'**il comprend en outre une seconde couche magnétique d'aimantation piégée (450), dite seconde couche piégée, séparée de ladite couche sensible par une seconde couche séparatrice (440) de découplage magnétique, les première et seconde couches séparatrices étant situées de part et d'autre de ladite couche sensible, les aimantations respectives de ladite première couche piégée et de ladite couche sensible, en absence de champ extérieur, étant sensiblement orthogonales, ledit capteur étant adapté à faire circuler un courant continu de la première couche piégée à la seconde couche piégée, et l'aimantation ($\pi_2$) de la seconde couche piégée étant orientée dans une direction intermédiaire entre celle de l'aimantation ($\pi_1$) de la première couche piégée et la direction de l'aimantation ($M_0$) de ladite couche sensible, en absence de champ extérieur, l'aimantation de la seconde couche piégée présentant une composante parallèle à l'aimantation de couche sensible, en l'absence de champ extérieur, de sorte à stabiliser l'aimantation de la couche sensible.

**2.** Capteur magnétorésistif comprenant une première couche magnétique d'aimantation piégée (410), dite première couche piégée, et une couche magnétique d'aimantation libre (430), dite couche sensible, séparées par une première couche séparatrice (420) de découplage magnétique, **caractérisé en ce qu'**il comprend en outre une seconde couche magnétique d'aimantation piégée (450), dite seconde couche piégée, séparée de ladite couche sensible par une seconde couche séparatrice (440) de découplage magnétique, les première et seconde couches séparatrices étant situées de part et d'autre de ladite couche sensible, les aimantations respectives de ladite première couche piégée et de ladite couche sensible, en absence de champ extérieur, étant sensiblement orthogonales, ledit capteur étant adapté à faire circuler un courant continu de la seconde couche piégée à la première couche piégée, l'aimantation ($\pi_2$) de la seconde couche piégée étant orientée dans une direction intermédiaire entre la direction de l'aimantation ($\pi_1$) de la première couche piégée et la direction opposée à celle de l'aimantation ($M_0$) de ladite couche sensible, en absence de champ extérieur, l'aimantation de la seconde couche piégée présentant une composante antiparallèle à l'aimantation de couche sensible, en l'absence de champ extérieur, de sorte à stabiliser l'aimantation de la couche sensible.

**3.** Capteur magnétorésistif comprenant une première couche magnétique d'aimantation piégée (410), dite première couche piégée, et une couche magnétique d'aimantation libre (430), dite couche sensible, séparées par une première couche séparatrice (420) de découplage magnétique, **caractérisé en ce qu'**il comprend en outre une seconde couche magnétique d'aimantation piégée (450), dite seconde couche piégée, séparée de ladite couche sensible par une seconde couche séparatrice (440) de découplage magnétique, les première et seconde couches séparatrices étant situées de part et d'autre de ladite couche sensible, les aimantations respectives de ladite première couche piégée et de ladite couche sensible, en absence de champ extérieur, étant sensiblement orthogonales, ledit capteur étant adapté à faire circuler un courant continu de la première couche piégée à la seconde couche piégée, l'aiman-

tation ($\pi_2$) de la seconde couche piégée étant orientée dans une direction intermédiaire entre la direction opposée à celle de l'aimantation ($\pi_1$) de la première couche piégée et la direction opposée à celle de l'aimantation ($M_0$) de ladite couche sensible, en absence de champ extérieur, l'aimantation de la seconde couche piégée présentant, en l'absence de champ extérieur, une composante antiparallèle à l'aimantation de la couche sensible de sorte à stabiliser l'aimantation de la couche sensible.

4. Capteur magnétorésistif comprenant une première couche magnétique d'aimantation piégée (410), dite première couche piégée, et une couche magnétique d'aimantation libre (430), dite couche sensible, séparées par une première couche séparatrice (420) de découplage magnétique, **caractérisé en ce qu'**il comprend en outre une seconde couche magnétique d'aimantation piégée (450), dite seconde couche piégée, séparée de ladite couche sensible par une seconde couche séparatrice (440) de découplage magnétique, les première et seconde couches séparatrices étant situées de part et d'autre de ladite couche sensible, les aimantations respectives de ladite première couche piégée et de ladite couche sensible, en absence de champ extérieur, étant sensiblement orthogonales, ledit capteur étant adapté à faire circuler un courant continu de la seconde couche piégée à la première couche piégée, l'aimantation ($\pi_2$) de la seconde couche piégée étant orientée dans une direction intermédiaire entre la direction opposée à celle de l'aimantation ($\pi_1$) de la première couche piégée et celle de l'aimantation ($M_0$) de ladite couche sensible, en absence de champ extérieur, l'aimantation de la seconde couche piégée présentant, en l'absence de champ extérieur, une composante parallèle à l'aimantation de la couche sensible de sorte à stabiliser l'aimantation de la couche sensible.

5. Capteur magnétorésistif selon l'une des revendications précédentes, **caractérisé en ce que** la résistance électrique de l'ensemble couche sensible/première couche séparatrice/première couche piégée est sensiblement plus grande que la résistance électrique de l'ensemble couche sensible/deuxième couche séparatrice/deuxième couche piégée.

6. Capteur magnétorésistif selon l'une des revendications précédentes, **caractérisé en ce que** la première couche séparatrice est une couche mince d'isolant formant une barrière tunnel.

7. Capteur magnétorésistif selon l'une des revendications 1 à 5, **caractérisé en ce que** la première couche séparatrice est une couche métallique.

8. Capteur magnétorésistif selon l'une des revendications 1 à 5, **caractérisé en ce que** la première couche séparatrice est une couche composite métal-isolant, adaptée à confiner localement les lignes de courant.

9. Capteur magnétorésistif selon l'une des revendications précédentes, **caractérisé en ce que** la seconde couche séparatrice est une couche métallique.

10. Capteur magnétorésistif selon les revendications 7 et 9, **caractérisé en ce que** la résistance surfacique de la seconde couche séparatrice est sensiblement plus faible que celle de la première couche séparatrice.

11. Capteur magnétorésistif selon l'une des revendications 1 à 8, **caractérisé en ce que** la seconde couche séparatrice est une couche composite métal-isolant, adaptée à confiner localement les lignes de courant.

12. Capteur magnétorésistif selon l'une des revendications précédentes, **caractérisé en ce qu'**il comprend une première couche ferrimagnétique synthétique, constituée d'une première et d'une seconde sous-couches magnétiques prenant en sandwich une première sous-couche de couplage antiferromagnétique, la première sous-couche magnétique étant piégée par une première couche antiferromagnétique de piégeage, la seconde sous-couche magnétique constituant la première couche piégée.

13. Capteur magnétorésistif selon l'une des revendications précédentes, **caractérisé en ce qu'**il comprend une seconde couche ferrimagnétique synthétique, constituée d'une troisième et quatrième sous-couches magnétiques prenant en sandwich une seconde sous-couche de couplage antiferromagnétique, la quatrième sous-couche magnétique étant piégée par une seconde couche antiferromagnétique de piégeage, la troisième sous-couche magnétique constituant la seconde couche piégée.

14. Capteur magnétorésistif selon l'une des revendications 1 à 12, **caractérisé en ce qu'**il comprend une seconde couche ferrimagnétique synthétique, constituée d'une troisième et quatrième sous-couches magnétiques prenant en sandwich une seconde sous-couche de couplage antiferromagnétique, la quatrième sous-couche magnétique étant piégée par une couche en matériau magnétique dur, la troisième sous-couche magnétique constituant la seconde couche piégée.

15. Capteur magnétorésistif selon la revendication 1, **caractérisé en ce que** la première couche piégée a son aimantation piégée dans une première direction par une première couche antiferromagnétique de piégeage ayant une première température de blocage, et que la seconde couche piégée a son aimantation piégée dans une seconde direction par une seconde couche antiferromagnétique de piégeage ayant une seconde température de blocage distincte de la première.

16. Procédé de fabrication d'un capteur magnétorésistif selon la revendication 15, **caractérisé en ce que** l'on dépose successivement sur une électrode la première couche antiferromagnétique de piégeage, la première couche piégée, la première couche séparatrice, la couche sensible, la seconde couche séparatrice, la seconde couche piégée, la seconde couche antiferromagnétique de piégeage, et **en ce que** :

- si la première température de blocage est supérieure à la seconde température de blocage, on effectue un recuit des couches sous un champ magnétique orienté selon ladite première direction, puis on descend en température jusqu'à la seconde température de blocage, on oriente alors le champ magnétique selon ladite seconde direction et on descend en température jusqu'à la température ambiante ;
- si la seconde température de blocage est supérieure à la première température de blocage, on effectue un recuit des couches sous un champ magnétique orienté selon ladite seconde direction, puis on descend en température jusqu'à la première température de blocage, on oriente alors le champ magnétique selon ladite première direction et on descend en température jusqu'à la température ambiante.

## Claims

1. A magnetoresistive sensor comprising a first pinned-magnetization magnetic layer (410), called first pinned layer, and a second free-magnetization magnetic layer (430), called sensitive layer, separated by a first separating layer (420) for magnetic uncoupling, wherein it further comprises a second pinned-magnetization magnetic layer (450), called second pinned layer, separated from said sensitive layer by a second separating layer (440) for magnetic uncoupling, the first and second separating layers being located on either side of said sensitive layer, the respective magnetizations of said first pinned layer and of said sensitive layer, in the absence of an external field, being substantially orthogonal, said sensor being suitable for circulating a continuous current from the first pinned layer to the second pinned layer, and the magnetization ($\pi_2$) of the second pinned layer being oriented in an intermediate direction between the magnetization direction ($\pi_1$) of the first pinned layer and the magnetization direction ($\mathbf{M}_0$) of said sensitive layer, in the absence of an external field, the magnetization of the second pinned layer having a component parallel to the magnetization of the sensitive layer, in absence of an external field, so as to stabilize the magnetization of the sensitive layer.

2. A magnetoresistive sensor comprising a first pinned-magnetization magnetic layer (410), called first pinned layer, and a second free-magnetization magnetic layer (430), called sensitive layer, separated by a first separating layer (420) for magnetic uncoupling, wherein it further comprises a second pinned-magnetization magnetic layer (450), called second pinned layer, separated from said sensitive layer by a second separating layer (440) for magnetic uncoupling, the first and second separating layers being located on either side of said sensitive layer, the respective magnetizations of said first pinned layer and of said sensitive layer, in the absence of an external field, being substantially orthogonal, said sensor being suitable for circulating a continuous current from the first pinned layer to the second pinned layer, and the magnetization ($\pi_2$) of the second pinned layer being oriented in an intermediate direction between the magnetization direction ($\pi_1$) of the first pinned layer and the direction opposite to the magnetization direction ($\mathbf{M}_0$) of said sensitive layer, in the absence of an external field, the magnetization of the second pinned layer having a component antiparallel to the magnetization of the sensitive layer, in absence of an external field, so as to stabilize the magnetization of the sensitive layer.

3. A magnetoresistive sensor comprising a first pinned-magnetization magnetic layer (410), called first pinned layer, and a second free-magnetization magnetic layer (430), called sensitive layer, separated by a first separating layer (420) for magnetic uncoupling, wherein it further comprises a second pinned-magnetization magnetic layer (450), called second pinned layer, separated from said sensitive layer by a second separating layer (440) for magnetic uncoupling, the first and second separating layers being located on either side of said sensitive layer, the respective magnetizations of said first pinned layer and of said sensitive layer, in the absence of an external field, being substantially orthogonal, said sensor being suitable for circulating a continuous current from the first pinned layer to the second pinned layer, and the magnetization ($\pi_2$) of the second pinned layer being oriented in an intermediate direction between the direction opposite to the magnetization direction ($\pi_1$) of the first pinned layer and the direction opposite to the magnetization direction ($M_0$) of said sensitive layer, in the absence of an external field, the magnetization of said second pinned layer having, in absence of an external field, a component antiparallel to the magnetization of the sensitive layer so as to stabilize the magnetization of the sensitive layer.

4. A magnetoresistive sensor comprising a first pinned-magnetization magnetic layer (410), called first pinned layer, and a second free-magnetization magnetic layer (430), called sensitive layer, separated by a first separating layer (420) for magnetic uncoupling, wherein it further comprises a second pinned-magnetization magnetic layer (450), called second pinned layer, separated from said sensitive layer by a second separating layer (440) for magnetic uncoupling, the first and second separating layers being located on either side of said sensitive layer, the respective magnetizations of said first pinned layer and of said sensitive layer, in the absence of an external field, being substantially orthogonal, said sensor being suitable for circulating a continuous current from the first pinned layer to the second pinned layer, and the magnetization ($\pi_2$) of the second pinned layer being oriented in an intermediate direction between the direction opposite to the magnetization direction ($\pi_1$) of the first pinned layer and the magnetization direction ($M_0$) of said sensitive layer, in the absence of an external field, the magnetization of said second pinned layer having, in absence of an external field, a component parallel to the magnetization of the sensitive layer so as to stabilize the magnetization of the sensitive layer.

5. The magnetoresistive sensor as claimed in one of the preceding claims, wherein the electrical resistance of the sensitive layer/first separating layer/first pinned layer stack is substantially higher than the electrical resistance of the sensitive layer/second separating layer/second pinned layer stack.

6. The magnetoresistive sensor as claimed in one of the preceding claims, wherein the first separating layer is a thin layer of insulation forming a tunnel barrier.

7. The magnetoresistive sensor as claimed in one of claims 1 to 5, wherein the first separating layer is a metal layer.

8. The magnetoresistive sensor as claimed in one of claims 1 to 5, wherein the first separating layer is a composite metal-insulation layer, suitable for locally confining the current paths.

9. The magnetoresistive sensor as claimed in one of the preceding claims, wherein the second separating layer is a metal layer.

10. The magnetoresistive sensor as claimed in claims 7 and 9, wherein the surface resistance of the second separating layer is substantially lower than that of the first separating layer.

11. The magnetoresistive sensor as claimed in one of claims 1 to 8, wherein the second separating layer is a composite metal-insulation layer, suitable for locally confining the current paths.

12. The magnetoresistive sensor as claimed in one of the preceding claims, wherein it comprises a first synthetic ferrimagnetic layer, consisting of first and second magnetic sub-layers containing a first antiferromagnetic coupling layer in a sandwich, the first magnetic sub-layer being pinned by a first antiferromagnetic pinning layer, the second magnetic sub-layer constituting the first pinned layer.

13. The magnetoresistive sensor as claimed in one of the preceding claims, wherein it comprises a second synthetic ferrimagnetic layer, consisting of third and fourth magnetic sub-layers containing a second antiferromagnetic coupling layer in a sandwich, the fourth magnetic sub-layer being pinned by a second pinning antiferromagnetic layer, the third magnetic sub-layer constituting the second pinned layer.

14. The magnetoresistive sensor as claimed in one of the claims 1 to 12, wherein it comprises a second synthetic ferrimagnetic layer, consisting of third and fourth magnetic sub-layers containing a second antiferromagnetic coupling layer in a sandwich, the fourth magnetic sub-layer being pinned by a layer of hard magnetic material, the third magnetic-layer constituting the second pinned layer.

15. The magnetoresistive sensor as claimed in claim 1, wherein the first pinned layer has its magnetization pinned in a first direction by a first pinning antiferromagnetic layer having a first blocking temperature, and wherein the second pinned layer has its magnetization pinned in a second direction by a second pinning antiferromagnetic layer having a second blocking temperature different from the first.

16. A method for fabricating a magnetoresistive sensor as claimed in claim 15, wherein the first pinning antiferromagnetic layer, the first pinned layer, the first separating layer, the sensitive layer, the second separating layer, the second pinned layer, the second pinning antiferromagnetic layer, are deposited in succession on an electrode, and wherein:

- if the first blocking temperature is higher than the second blocking temperature, the layers are annealed under a magnetic field oriented along said first direction, the temperature is then lowered to the second blocking temperature, the magnetic field is then oriented along said second direction, and the temperature is lowered to the ambient temperature;
- if the second blocking temperature is higher than the first blocking temperature, the layers are annealed under a magnetic field oriented along said second direction, the temperature is then lowered to the first blocking temperature, the magnetic field is then oriented along said first direction, and the temperature is lowered to the ambient temperature.

## Patentansprüche

1. Magnetoresistiver Sensor, umfassend eine erste magnetische Schicht mit gefangener Magnetisierung (410), genannt erste gefangene Schicht, sowie eine magnetische Schicht mit freier Magnetisierung (430), genannt sensible Schicht, die durch eine erste Trennschicht (420) zur magnetischen Entkopplung voneinander getrennt sind, **dadurch gekennzeichnet, dass** er ferner eine zweite magnetische Schicht mit gefangener Magnetisierung (450) umfasst, genannt zweite gefangene Schicht, die von der sensiblen Schicht durch eine zweite Trennschicht (440) zur magnetischen Entkopplung getrennt ist, wobei die erste und die zweite Trennschicht auf beiden Seiten der sensiblen Schicht angeordnet sind, wobei die jeweiligen Magnetisierungen der ersten gefangenen Schicht und der sensiblen Schicht in Abwesenheit eines äußeren Felds im Wesentlichen orthogonal zueinander sind, wobei der Sensor dazu ausgelegt ist, einen Gleichstrom von der ersten gefangenen Schicht zur zweiten gefangenen Schicht fließen zu lassen, und die Magnetisierung ($\pi_2$) der zweiten gefangenen Schicht in einer Zwischenrichtung zwischen jener der Magnetisierung ($\pi_1$) der ersten gefangenen Schicht und der Richtung der Magnetisierung ($M_0$) der sensiblen Schicht in Abwesenheit eines äußeren Felds orientiert ist, wobei die Magnetisierung der zweiten gefangenen Schicht eine Komponente parallel zur Magnetisierung der sensiblen Schicht in Abwesenheit eines äußeren Felds aufweist, derart, dass die Magnetisierung der sensiblen Schicht stabilisiert wird.

2. Magnetoresistiver Sensor, umfassend eine erste magnetische Schicht mit gefangener Magnetisierung (410), genannt erste gefangene Schicht, sowie eine magnetische Schicht mit freier Magnetisierung (430), genannt sensible Schicht, die durch eine erste Trennschicht (420) zur magnetischen Entkopplung voneinander getrennt sind, **dadurch gekennzeichnet, dass** er ferner eine zweite magnetische Schicht mit gefangener Magnetisierung (450) umfasst, genannt zweite gefangene Schicht, die von der sensiblen Schicht durch eine zweite Trennschicht (440) zur magnetischen Entkopplung getrennt ist, wobei die erste und die zweite Trennschicht auf beiden Seiten der sensiblen Schicht angeordnet sind, wobei die jeweiligen Magnetisierungen der ersten gefangenen Schicht und der sensiblen Schicht in Abwesenheit eines äußeren Felds im Wesentlichen orthogonal zueinander sind, wobei der Sensor dazu ausgelegt ist, einen Gleichstrom von der zweiten gefangenen Schicht zur ersten gefangenen Schicht fließen zu lassen, wobei die Magnetisierung ($\pi_2$) der zweiten gefangenen Schicht in einer Zwischenrichtung zwischen der Richtung der Magnetisierung ($\pi_1$) der ersten gefangenen Schicht und der Richtung entgegengesetzt zu jener der Magnetisierung ($M_0$) der sensiblen Schicht in Abwesenheit eines äußeren Felds orientiert ist, wobei die Magnetisierung der zweiten gefangenen Schicht eine Komponente anti-parallel zur Magnetisierung der sensiblen Schicht in Abwesenheit eines äußeren Felds aufweist, derart, dass die Magnetisierung der sensiblen Schicht stabilisiert wird.

3. Magnetoresistiver Sensor, umfassend eine erste magnetische Schicht mit gefangener Magnetisierung (410), genannt erste gefangene Schicht, sowie eine magnetische Schicht mit freier Magnetisierung (430), genannt sensible Schicht, die durch eine erste Trennschicht (420) zur magnetischen Entkopplung voneinander getrennt sind, **dadurch gekennzeichnet, dass** er ferner eine zweite magnetische Schicht mit gefangener Magnetisierung (450) umfasst, genannt zweite gefangene Schicht, die von der sensiblen Schicht durch eine zweite Trennschicht (440) zur magnetischen Entkopplung getrennt ist, wobei die erste und die zweite Trennschicht auf beiden Seiten der sensiblen Schicht angeordnet sind, wobei die jeweiligen Magnetisierungen der ersten gefangenen Schicht und der sensiblen Schicht in Abwesenheit eines äußeren Felds im Wesentlichen orthogonal zueinander sind, wobei der Sensor dazu ausgelegt ist, einen Gleichstrom von der ersten gefangenen Schicht zur zweiten gefangenen Schicht fließen zu lassen, wobei die Magnetisierung ($\Pi_2$) der zweiten gefangenen Schicht in einer Zwischenrichtung zwischen der Richtung entgegengesetzt zu jener der Magnetisierung ($\Pi_1$) der ersten gefangenen Schicht und der Richtung entgegengesetzt zu jener der Magnetisierung ($M_0$) der sensiblen Schicht in Abwesenheit eines äußeren Felds orientiert ist, wobei die Magnetisierung der zweiten gefangenen Schicht in Abwesenheit eines äußeren Felds eine Komponente anti-parallel zur Magnetisierung der sensiblen Schicht aufweist, derart, dass die Magnetisierung der sensiblen Schicht stabilisiert wird.

4.  Magnetoresistiver Sensor, umfassend eine erste magnetische Schicht mit gefangener Magnetisierung (410), genannt erste gefangene Schicht, sowie eine magnetische Schicht mit freier Magnetisierung (430), genannt sensible Schicht, die durch eine erste Trennschicht (420) zur magnetischen Entkopplung voneinander getrennt sind, **dadurch gekennzeichnet, dass** er ferner eine zweite magnetische Schicht mit gefangener Magnetisierung (450) umfasst, genannt zweite gefangene Schicht, die von der sensiblen Schicht durch eine zweite Trennschicht (440) zur magnetischen Entkopplung getrennt ist, wobei die erste und die zweite Trennschicht auf beiden Seiten der sensiblen Schicht angeordnet sind, wobei die jeweiligen Magnetisierungen der ersten gefangenen Schicht und der sensiblen Schicht in Abwesenheit eines äußeren Felds im Wesentlichen orthogonal zueinander sind, wobei der Sensor dazu ausgelegt ist, einen Gleichstrom von der zweiten gefangenen Schicht zur ersten gefangenen Schicht fließen zu lassen, wobei die Magnetisierung ($\Pi_2$) der zweiten gefangenen Schicht in einer Zwischenrichtung zwischen der Richtung entgegengesetzt zu jener der Magnetisierung ($\Pi_1$) der ersten gefangenen Schicht und jener der Magnetisierung ($M_0$) der sensiblen Schicht in Abwesenheit eines äußeren Felds orientiert ist, wobei die Magnetisierung der zweiten gefangenen Schicht in Abwesenheit eines äußeren Felds eine Komponente parallel zur Magnetisierung der sensiblen Schicht aufweist, derart, dass die Magnetisierung der sensiblen Schicht stabilisiert wird.

5.  Magnetoresistiver Sensor nach einem der vorhergehenden Ansprüche, **dadurch gekennzeichnet, dass** der elektrische Widerstand der Gesamtanordnung aus sensibler Schicht/erster Trennschicht/erster gefangener Schicht wesentlich größer ist als der elektrische Widerstand der Gesamtanordnung aus sensibler Schicht/zweiter Trennschicht/zweiter gefangener Schicht.

6.  Magnetoresistiver Sensor nach einem der vorhergehenden Ansprüche, **dadurch gekennzeichnet, dass** die erste Trennschicht eine dünne Isolierschicht ist, die eine Tunnelbarriere bildet.

7.  Magnetoresistiver Sensor nach einem der Ansprüche 1 - 5, **dadurch gekennzeichnet, dass** die erste Trennschicht eine metallische Schicht ist.

8.  Magnetoresistiver Sensor nach einem der Ansprüche 1 - 5, **dadurch gekennzeichnet, dass** die erste Trennschicht eine Metall-Isolator-Verbundschicht ist, die dazu ausgelegt ist, die Stromlinien lokal einzusperren.

9.  Magnetoresistiver Sensor nach einem der vorhergehenden Ansprüche, **dadurch gekennzeichnet, dass** die zweite Trennschicht eine metallische Schicht ist.

10. Magnetoresistiver Sensor nach den Ansprüchen 7 und 9, **dadurch gekennzeichnet, dass** der Oberflächenwiderstand der zweiten Trennschicht wesentlich kleiner ist als jener der ersten Trennschicht.

11. Magnetoresistiver Sensor nach einem der Ansprüche 1 und 8, **dadurch gekennzeichnet, dass** die zweite Trennschicht eine Metall-Isolator-Verbundschicht ist, die dazu ausgelegt ist, die Stromlinien lokal einzusperren.

12. Magnetoresistiver Sensor nach einem der vorhergehenden Ansprüche, **dadurch gekennzeichnet, dass** er eine erste synthetische ferrimagnetische Schicht umfasst, gebildet durch eine erste und eine zweite magnetische Unterschicht, die eine erste Unterschicht zur antiferromagnetischen Kopplung sandwichförmig einschließen, wobei die erste magnetische Unterschicht durch eine erste antiferromagnetische Fangschicht gefangen ist, wobei die zweite magnetische Unterschicht die erste gefangene Schicht bildet.

13. Magnetoresistiver Sensor nach einem der vorhergehenden Ansprüche, **dadurch gekennzeichnet, dass** er eine zweite synthetische ferrimagnetische Schicht umfasst, gebildet durch eine dritte und eine vierte magnetische Unterschicht, die eine zweite Unterschicht zur antiferromagnetischen Kopplung sandwichförmig einschließen, wobei die vierte magnetische Unterschicht durch eine zweite antiferromagnetische Fangschicht gefangen ist, wobei die dritte magnetische Unterschicht die zweite gefangene Schicht bildet.

14. Magnetoresistiver Sensor nach einem der Ansprüche 1 bis 12, **dadurch gekennzeichnet, dass** er eine zweite synthetische ferrimagnetische Schicht umfasst, gebildet durch eine dritte und eine vierte magnetische Unterschicht, die eine zweite Unterschicht zur antiferromagnetischen Kopplung sandwichförmig einschließen, wobei die vierte magnetische Unterschicht durch eine Schicht aus hartmagnetischem Material gefangen ist, wobei die dritte magnetische Unterschicht die zweite gefangene Schicht bildet.

15. Magnetoresistiver Sensor nach Anspruch 1, **dadurch gekennzeichnet, dass** die Magnetisierung der ersten gefangenen Schicht in einer ersten Richtung durch eine erste antiferromagnetische Fangschicht gefangen ist, die eine erste Blockiertemperatur hat, und dass die Magnetisierung der zweiten gefangenen Schicht in einer zweiten Richtung durch eine zweite antiferromagnetische Fangschicht gefangen ist, die eine zweite Blockiertemperatur hat, welche von der ersten verschieden ist.

16. Verfahren zur Herstellung eines magnetoresistiven Sensors nach Anspruch 15, **dadurch gekennzeichnet, dass** man nacheinander auf einer Elektrode die erste antiferromagnetische Fangschicht, die erste gefangene Schicht, die erste Trennschicht, die sensible Schicht, die zweite Trennschicht, die zweite gefangene Schicht und die zweite antiferromagnetische Fangschicht aufbringt, und dass:

- wenn die erste Blockiertemperatur größer als die zweite Blockiertemperatur ist, man eine Temperung der Schichten in einem magnetischen Feld durchführt, das entlang der ersten Richtung orientiert ist, dann die Temperatur bis zur zweiten Blockiertemperatur senkt, man dann das magnetische Feld entlang der zweiten Richtung orientiert, und man die Temperatur bis zur Umgebungstemperatur senkt;
- wenn die zweite Blockiertemperatur größer als die erste Blockiertemperatur ist, man eine Temperung der Schichten in einem magnetischen Feld durchführt, das entlang der zweiten Richtung orientiert ist, man dann die Temperatur bis zur ersten Blockiertemperatur senkt, man dann das magnetische Feld entlang der ersten Richtung orientiert, und man die Temperatur bis zur Umgebungstemperatur senkt.

FIG.1

FIG.2

FIG.3

FIG.4

FIG.5A

EP 2 167 984 B1

FIG.5B

EP 2 167 984 B1

## FIG.5C

FIG.5D

**EP 2 167 984 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 9744781 A
- US 2005041342 A
- US 688742 A
- US 2005280058 A

**Littérature non-brevet citée dans la description**

- **B. Dieny.** Giant magnetoresistance in spin-valve multilayers. *Journ. Magn. Mater.,* 1994, vol. 136, 335-359
- **N. Smith et al.** White-noise magnetization fluctuations in magnetoresistive heads. *Appl. Phys. Lett.,* 2001, vol. 78, 1148-1150
- **L. Berger.** *Phys. Rev. B,* vol. 54 (13), 9353-9539
- **J.C. Slonczewski.** Emission of spin waves by a magnetic multilayer traversed by a current. *Journal Magn. Magn.,* 1996, vol. 159, L1-L7
- Magnetization dynamics with a spin-transfer torque. *Physical Review B,* 2003, vol. 68, 024404

26